# EUROPÄISCHE PATENTANMELDUNG

(11) **EP 4 739 015 A1**
(43) Veröffentlichungstag der Anmeldung: **06.05.2026**
(21) Anmeldenummer: 24210725.8
(22) Anmeldetag: 05.11.2024
(51) Int. Cl.: H05K 7/20, B25F 5/00

(54) **DRUCKSTÜCK**

(71) Anmelder: Hilti Aktiengesellschaft, 9494 Schaan (LI)
(72) Erfinder: Zacher, Martin, 86845 Großaitingen (DE); Schneider, Markus, 92339 Beilngries (DE); Ullrich, Benjamin, 86825 Bad Wörishofen (DE)
(74) Vertreter: Hilti Aktiengesellschaft Corporate Intellectual Property

(57) **Zusammenfassung**

Die vorliegende Erfindung betrifft ein Druckstück (115) für eine Steuervorrichtung (111) für eine mobile Werkzeugmaschine (100) zum Andrücken einer bestückten Leiterplatte (117) an eine Wärmeleitschicht (119), enthaltend einen Boden (136) und zumindest zwei Rippen (123, 127, 129), welche von dem Boden (136) vorstehen, wobei zwischen den Rippen (123, 127, 129) zumindest ein Strömungskanal (133) von zumindest einem Einströmfenster (130) zu zumindest einem Ausströmfenster (131) gebildet ist, welcher zum Leiten eines Vergussmassestroms von dem Einströmfenster (130) um zumindest ein in den Strömungskanal (133) hineinragendes Bauelement (118, 124, 125) herum zu dem Ausströmfenster (131) konfiguriert ist.

## Beschreibung

### GEBIET DER ERFINDUNG

Die vorliegende Erfindung betrifft ein Druckstück für eine Steuervorrichtung für eine mobile Werkzeugmaschine zum Andrücken einer bestückten Leiterplatte an eine Wärmeleitschicht. Außerdem betrifft die vorliegende Erfindung eine Steuervorrichtung für eine mobile Werkzeugmaschine, eine mobile Werkzeugmaschine mit einer solchen Steuervorrichtung, und ein Verfahren zum Herstellen einer Steuervorrichtung.

Eine Leiterplatte einer Steuervorrichtung einer mobilen Werkzeugmaschine trägt Bauelemente, wie beispielsweise Leistungsbauelemente, die in einem Betrieb der mobilen Werkzeugmaschine Wärme entwickeln können. Um diese Wärme im Betrieb abzuführen, kontaktiert die Leiterplatte einen Kühler meist über eine zwischengeschaltete Wärmeleitschicht. Zum Sicherstellen eines gewissen Mindest-Wärmeübergangs wird die Leiterplatte mittels eines Druckstücks an die Wärmeleitschicht angedrückt. Üblicherweise stehen die Bauelemente von einer von dem Kühler abgewandten Seite der Leiterplatte vor.

Die Leiterplatte und die Bauelemente werden häufig mit einer Vergussmasse vergossen, um einen Halt der Bauelemente an der Leiterplatte über eine typische Lebensdauer einer mobilen Werkzeugmaschine sicherzustellen. Dabei kann es in dem beengten Raum zwischen dem Druckstück und der Leiterplatte um die Bauelemente herum zu Lufteinschlüssen kommen. Solche Lufteinschlüsse reduzieren eine Befestigungswirkung der Vergussmasse. Wenn ein Lufteinschluss zu einem Rand der Vergussmasse offen ist, können Verschmutzungen, wie Stäube oder Schmierstoffe, in Kontakt mit der Leiterplatte oder deren Bauelementen kommen mit möglichen Folgen wie mechanischem Verschleiß, Kurzschlüssen oder unerwünschten chemischen Reaktionen. Außerdem verschlechtern Lufteinschlüsse einen Wärmeübergang, der stattdessen über die Vergussmasse erfolgen könnte. Beispielsweise beträgt ein Wärmeleitkoeffizient von Luft etwa 0,0206 W/mK, wohingegen ein Wärmeleitkoeffizient von Epoxidharz ohne Zuschlagstoffe etwa 0,60 W/mK beträgt.

Übliche Methoden zum Verringern von Lufteinschlüssen in Vergussmassen haben jeweils eigene Nachteile. Beispielsweise kann ein Vibrieren zu einem - durch die Vergussmasse eigentlich zu verhindernden - Lockern von Bauelementen führen. Beispielsweise kann ein Verdünnen von Vergussmasse zu einem Verlängern einer Dauer bis zu einem nächsten Fertigungsschritt führen (bspw. verlängerte Dauer bis zu einem Aushärten). Beispielsweise kann ein Erwärmen zu einer - durch das Entfernen der Lufteinschlüsse eigentlich zu verhindernden - thermischen Belastung/Schädigung der Bauelemente führen.

Eine Aufgabe der vorliegenden Erfindung ist es daher, Mittel zum Verbessern einer Steuervorrichtung für eine mobile Werkzeugmaschine, insbesondere zum Reduzieren von Lufteinschlüssen während eines Vergießens, bereitzustellen.

### OFFENBARUNG DER ERFINDUNG

Demgemäß wird ein Druckstück für eine Steuervorrichtung für eine mobile Werkzeugmaschine vorgeschlagen, welches geeignet und/oder vorgesehen ist zum Andrücken einer bestückten Leiterplatte an eine Wärmeleitschicht. Das Druckstück hat einen Boden bzw. Bodenabschnitt und zumindest zwei Rippen bzw. Rippenabschnitte, welche von dem Boden vorstehen. Zwischen den zumindest zwei Rippen ist zumindest ein Strömungskanal von einem Einströmfenster zu einem Ausströmfenster gebildet. Der Strömungskanal ist zum Leiten eines Vergussmassestroms von dem zumindest einen Einströmfenster um zumindest ein in den Strömungskanal hineinragendes Bauelement herum zu dem Ausströmfenster konfiguriert und/oder vorbereitet.

Indem das Druckstück zumindest einen Strömungskanal oder zumindest einen Strömungskanal mit mehreren Kanalabschnitten hat, wird eine Umströmung von in den Strömungskanal hineinragenden bzw. eingreifenden Bauelementen einer an das Druckstück anliegenden/angedrückten bestückten Leiterplatte durch eine Vergussmasse während eines Vergießens erreicht. Indem die Rippen den Vergussmassestroms zu dem Auslassfenster leiten, werden Lufteinschlüsse signifikant verringert, sodass sich im Ergebnis ein besserer Halt der Bauelemente und eine verbesserte Wärmeleitung von dem jeweiligen Bauelement weg ergeben.

Man kann sagen, dass die Leiterplatte mit Bauelementen bestückt ist, und dass der Strömungskanal zum Leiten eines Vergussmassestroms von dem zumindest einen Einströmfenster um zumindest ein von der Leiterplatte in den Strömungskanal hineinragendes Bauelement herum zu dem Ausströmfenster konfiguriert und/oder vorbereitet ist.

Man kann auch sagen, dass der Strömungskanal konfiguriert ist, um in einem Zustand, wenn eine Leiterplatte auf die Rippen aufliegt, einen Vergussmassestrom von dem Strömungskanaleinlass um von der Leiterplatte in den Strömungskanaleinlass hineinragende Bauelemente der Leiterplatter herum zu dem Strömungskanalauslass zu leiten.

Man kann sagen, dass es sich um ein Druckstück zum Andrücken einer bestückten Leiterplatte an eine Wärmeleitschicht zum Sicherstellen eines Wärmeübergangs von der Leiterplatte in die Wärmeleitschicht handelt.

Es kann sein, dass das Druckstück unterschiedlich hohe Rippen hat. In diesem Fall kann man sagen, dass die zum Andrücken einer ebenen Leiterplatte gestalteten Rippen den zumindest einen Strömungskanal bilden. Man kann sagen, dass von einer Bezugsebene gleich weit vorstehende und/oder am weitesten vorstehende Rippen des Druckstücks die zum Andrücken einer ebenen Leiterplatte gestalteten Rippen sind. Somit sind weitere Rippen beispielsweise zum Einstellen einer Vergussmasse-Strömung vorsehbar. Man kann davon sprechen, dass weitere (niedrigere) Rippen zum Erzeugen einer Drosselwirkung gebildet sein können.

Es kann sein, dass das Druckstück aus einem dauerhaft elastischen Material, insbesondere aus Silikon, gefertigt ist. Man kann auch sagen, dass das Druckstück aus einem langzeitelastischen Material gefertigt ist. Es kann beispielsweise sein, dass das Druckstück aus einem Kunststoff gefertigt ist, der zum Aufrechterhalten einer Vorspannung zum Andrücken der Leiterplatte an die Wärmeleitschicht über einen Zeitraum von beispielsweise mindestens 5 Jahren geeignet ist. Somit kann mittels des Druckstücks ein dauerhaft sicherer Sitz der Leiterplatte gewährleistet werden.

Dass das Druckstück andrückt bzw. zum Andrücken der Leiterplatte vorbereitet ist, bedeutet im Umkehrschluss, dass im Betrieb das Druckstück ein nachgiebiges Lager der Leiterplatte sein kann, sodass einerseits Vibrationsspitzen (d.h. maximale Kraftspitzen) abgefedert und andererseits eine eventuelle mechanische Schwingung der Leiterplatte gedämpft werden.

Es kann sein, dass das Druckstück einstückig gebildet ist, um homogene Materialeigenschaften des Druckstücks zu erreichen.

Es kann sein, dass das Druckstück innere bzw. innenliegende Rippen hat. Man kann auch sagen, dass es sein kann, dass zumindest eine innere Rippe von zumindest einem Strömungskanal umgeben ist. Innenliegende Rippen können eine Anpresskraft auf die Leiterplatte flächig verteilt aufbringen. Somit kann ein gleichmäßiger flächiger Kontakt zwischen der Leiterplatte und der Wärmeleitschicht erreicht werden. Dies kann eine Wärmeabfuhr aus der Leiterplatte verbessern / erhöhen.

Es kann sein, dass die Rippen nicht nur geradlinig verlaufen, beispielsweise um einer Bauteilanordnung der Leiterplatte und/oder Versteifungsstrukturen eines Gehäuses zu folgen / auszuweichen. Daher kann es sein, dass zumindest eine Rippe eine Tasche bildet. Man kann auch sagen, dass zumindest eine Rippe einen konkaven Bereich (teilweise) umschließt. Unter einer Tasche kann man einen Verlauf einer Rippe oder einen Verlauf mehrerer Rippen zusammen verstehen, welcher Verlauf in einer Draufsicht einen konkaven Bereich teilweise umschließt bzw. umgibt. Wenn zumindest eine Rippe in einem Bereich (der Rippe), der eine Tasche ausbildet, bzw. in einem konkaven Bereich durch zumindest ein Fenster unterbrochen ist, kann man ein "Fangen" eines Lufteinschlusses in der Tasche / in dem konkaven Bereich vermeiden.

Das geschilderte Druckstück hat somit einerseits die Wirkung, dass in einem Betrieb einer mobilen Werkzeugmaschine eine Leiterplatte an eine Wärmeleitschicht angedrückt wird, um ein Wärmeableiten aus der Leiterplatte über die Wärmeleitschicht zu verbessern. Das geschilderte Druckstück hat somit andererseits die Wirkung, dass während eines Herstellungsprozesses ein Vergussstrom zumindest Lufteinschluss-arm um von der Leiterplatte abstehende Bauelemente, insbesondere Leistungselektronikbauelemente, herumgeleitet wird, um deren Befestigung und Schutz und eine gute Wärmeableitung sicherzustellen.

Gemäß einem weiteren Aspekt der Erfindung wird eine Steuervorrichtung für eine mobile Werkzeugmaschine vorgeschlagen. Die vorgeschlagene Steuervorrichtung hat eine mit Bauelementen bestückte Leiterplatte, ein Druckstück und eine Wärmeleitschicht. Das Druckstück hat einen Boden und mehrere Rippen, welche von dem Boden vorstehen. Das Druckstück ist angeordnet, sodass die Rippen die Leiterplatte gegen die Wärmeleitschicht drücken. Die Rippen bilden zumindest einen Strömungskanal für einen Vergussmassenstrom von zumindest einem Einströmfenster zu zumindest einem Ausströmfenster. Bauelemente ragen von der Leiterplatte in den Strömungskanal hinein.

Indem das Druckstück zumindest einen Strömungskanal oder zumindest einen Strömungskanal mit mehreren Kanalabschnitten hat, wird eine Umströmung von in den Strömungskanal eingreifenden Bauelementen einer an das Druckstück anliegenden/angedrückten bestückten Leiterplatte durch eine Vergussmasse während eines Vergießens erreicht. Indem die Rippen den Vergussmassestrom zu dem Auslassfenster leiten, werden Lufteinschlüsse signifikant verringert, sodass sich im Ergebnis ein besserer Halt der Bauelemente und eine verbesserte Wärmeleitung von dem jeweiligen Bauelement weg ergeben.

Man kann sagen, dass die den Strömungskanal bildenden bzw. definierenden Rippen des Druckstücks an die Leiterplatte anliegen. Durch das Anliegen werden die Rippen des Druckstücks beispielsweise in einem vorbestimmten Maße elastisch verformt, wobei das Maß der Verformung sich beispielsweise aus einer für die Wärmeleitschicht angegebenen Anpresskraft und/oder Eindringtiefe und einer elastischen Verformbarkeit des Druckstücks ergibt. Ausgangspunkt für die angegebene Anpresskraft / Eindringtiefe kann beispielsweise eine Herstellervorgabe eines Herstellers der Wärmeleitschicht sein. Die Verformung des Druckstücks kann beispielsweise zumindest 0,5 mm und/oder bis zu 5 mm betragen. Die Verformung des Druckstücks kann beispielsweise 1,5 mm +/- 0,75 mm betragen.

Das Druckstück der Steuervorrichtung kann beispielsweise das eingangs vorgeschlagene Druckstück sein. Beispielsweise kann es sein, dass das Druckstück aus einem dauerhaft elastischen Material, beispielsweise aus Silikon, gefertigt ist. Beispielsweise kann es sein, dass zumindest eine innere Rippe des Druckstücks von zumindest einem Strömungskanal umgeben ist. Beispielsweise kann es sein, dass zumindest eine Rippe in einem eine Tasche ausbildenden Bereich durch ein Fenster unterbrochen ist. Die Steuervorrichtung kann also die Merkmale und Vorteile des vorgeschlagenen Druckstücks haben bzw. realisieren.

Die Leiterplatte ist mit den Bauelementen bestückt. Dabei kann es sich beispielsweise um elektrische und/oder elektromechanische Bauelemente und/oder um aktive und/oder passive Bauelemente handeln.

In den meisten Fällen werde nicht alle Bauelemente der Leiterplatte von der Leiterplatte in den Strömungskanal hineinragen. Es kann sein, dass die Leiterplatte mit Leistungselektronikbauelementen bestückt ist, wobei zumindest ein Teil der Leistungselektronikbauelemente zumindest ein Teil der in den Strömungskanal hineinragende Bauelemente ist. Die Leistungselektronikbauelemente sind beispielsweise gewählt aus: Feldeffekttransistoren, MOSFETs, Leistungstransistoren, Pulsdauermodulatoren, Gleichstrom-Wechselstrom-Umrichtern, Nebenschlusswiderständen und/oder Shunts. Leistungselektronikbauelemente sind häufig Wärmequellen. Sind die Leistungselektronikbauelemente zumindest Lufteinschluss-arm in der Vergussmasse umschlossen, kann daher Wärme der bestückten Leiterplatte besonders effizient abgeführt werden. Außerdem sind viele Leistungselektronikbauelemente relativ groß und schwer, sodass ein fester Halt durch die Vergussmasse eine Lebensdauer erhöht.

Es kann sein, dass die in den Strömungspfad hineinragenden Bauelemente jeweils in einem Strömungspfad zwischen zwei Fenstern angeordnet sind. Unter einem Strömungspfad zwischen zwei Fenstern kann man beispielsweise eine (gedachte) Gerade verstehen. Diese Option bewirkt, dass kein Leistungselektronikbauelement in einem "toten" Winkel "gefangen", wie in einem Hohleck zweier sich kreuzender Rippen bzw. Rippenabschnitte.

Die Steuervorrichtung ist hier meist in einem Zustand vor einem Vergießen mit Vergussmasse beschrieben. Es kann sein, dass der zumindest eine Strömungskanal mit einer Vergussmasse vergossen ist. Man kann sagen, dass die Steuervorrichtung eine Vergussschicht in dem zumindest einen Strömungskanal zwischen dem Druckstück und der Leiterplatte hat. Die Vergussschicht hat beispielsweise die Wirkung, dass von der Leiterplatte in den Strömungskanal ragende Bauelemente der Leiterplatte gehalten und/oder vor Verschmutzungen geschützt sind.

Es kann sein, dass die Vergussmasse als thermischer Puffer konfiguriert ist. Unter einem thermischen Puffer kann man eine Eignung zum Aufnehmen einer Abwärme einer kurzen Wärmespitze von einem der Bauelemente verstehen. Unter einem thermischen Puffer kann man eine Eignung zum Ableiten und/oder Verteilen einer Abwärme von einem der Bauelemente verstehen. Somit wird eine thermische Haltbarkeit der Steuervorrichtung verbessert / verlängert. Beispielsweise kann ein Epoxidharz Verwendung finden, das zumindest einen Zuschlagstoff für eine erhöhte Wärmeleitfähigkeit bei wenig oder nicht erhöhter elektrischer Leitfähigkeit hat (Epoxidharz ohne Zuschlagstoffe gilt als Isolator). Beispielsweise kann ein Epoxidharz mit einer Wärmeleitfähigkeit von zumindest 1 W/mK und/oder mit einer Wärmeleitfähigkeit von bis zu 5 W/mK Verwendung finden. Es wird hier rein beispielsweise auf den Werkstoff mit dem Handelsnamen "EPO-TEK 930" verwiesen, wobei der Fachmann problemlos weitere Werkstoffe für die Vergussmasse auswählen kann. Es wird auch darauf hingewiesen, dass es sein kann, dass die Leiterplatte eine nicht-leitende Oberfläche hat, beispielsweise mit einem dünnen Isolator beschichtet ist. In diesem Fall kann ein Epoxidharz mit zumindest einem Zuschlagstoff für eine erhöhte Wärmeleitfähigkeit von beispielsweise über 5 W/mK und/oder über 15 W/mK und/oder bis zu 40 W/mK Verwendung finden. In diesem Zusammenhang wird darauf hingewiesen, dass aktuelle mobile Werkzeugmaschinen intern häufig mit Spannungen deutlich unter 100 V operieren, sodass dünne Isolationsschichten zum Einsatz kommen können.

Es kann sein, dass die Steuervorrichtung einen Schichtaufbau in der folgenden Reihenfolge hat: ein Gehäuse, das Druckstück, die bestückte Leiterplatte, die Wärmeleitschicht und ein Kühler. Es kann sein, dass die Steuervorrichtung einen Schichtaufbau in der folgenden Reihenfolge hat: das Gehäuse, das Druckstück, die Vergussmasse, die bestückte Leiterplatte, die Wärmeleitschicht und der Kühler.

Das Gehäuse kann beispielsweise aus Kunststoff und/oder aus Aluminium gemacht sein. Das Gehäuse kann beispielsweise einstückig gebildet sein. Das Gehäuse kann zum Aufnehmen der Leiterplatte gestaltet sein. Das Gehäuse kann beispielsweise gestaltet sein, um die bestückte Leiterplatte an bis zu fünf Seiten zu umgeben. Das Gehäuse kann mehrteilig sein, wobei das Druckstück an einem Gehäuseteil anliegt, und wobei der Kühler ein anderes Gehäuseteil bildet. Das Gehäuse kann eine Wannenform haben, welche die bestückte Leiterplatte aufnimmt, sodass ein Verguss in der Wannenform leckagefrei vorgenommen werden kann.

Die Wärmeleitschicht kann beispielsweise eine Wärmeleitfolie oder eine Wärmeleitpaste sein und/oder enthalten.

Der Kühler kann beispielsweise ein Radiator sein. Der Kühler kann beispielsweise einen Lüfter haben und somit aktiv gekühlt sein. Der Kühler kann beispielsweise zum Anordnen in einem Luftstrom vorbereitet und somit passiv gekühlt bzw. kühlend sein.

Es kann sein, dass die Leiterplatte zwischen dem Druckstück und der Wärmeleitschicht schwimmend gelagert ist. Das Druckstück und die Wärmeleitschicht können somit zum schwimmenden Lagern der Leiterplatte dazwischen konfiguriert sein. Beispielsweise können das Druckstück und die Leiterplatte elastisch gebildet sein. Beispielsweise können das Druckstück und die Wärmeleitschicht jeweils ein (unterschiedliches) Elastomer sein und/oder Elastomer-Verhalten haben. Somit wird die Leiterplatte teilweise von Schwingungen und/oder Stößen entkoppelt, welche für einen Betrieb der mobilen Werkezugmaschine typisch sind.

Die geschilderte Steuervorrichtung hat somit einerseits die Wirkung, dass in einem Betrieb einer mobilen Werkzeugmaschine eine Leiterplatte an eine Wärmeleitschicht angedrückt wird, um ein Wärmeableiten aus der Leiterplatte über die Wärmeleitschicht zu verbessern. Die geschilderte Steuervorrichtung hat somit andererseits die Wirkung, dass während eines Herstellungsprozesses ein Vergussstrom zumindest Lufteinschluss-arm um von der Leiterplatte abstehende Bauelemente, insbesondere Leistungselektronikbauelemente, herumgeleitet wird, um deren Befestigung und Schutz und/oder eine gute Wärmeableitung sicherzustellen.

Gemäß einem nächsten Aspekt wird eine mobile Werkzeugmaschine vorgeschlagen, welche die vorgeschlagene Steuervorrichtung enthält. Somit hat die Werkzeugmaschine die Merkmale und Vorteile der Steuervorrichtung bzw. auch des Druckstücks.

Die mobile Werkzeugmaschine kann ein handgeführtes Elektrowerkzeug bzw. eine Handwerkzeugmaschine, beispielsweise eine Bohrmaschine, eine Schraubmaschine, eine Meißelmaschine, eine Schleifmaschine, eine Sägemaschine oder dergleichen sein. Denkbar ist auch, dass die mobile Werkzeugmaschine ein Bauroboter ist oder einen Bauroboter umfasst. Die mobile Werkzeugmaschine kann einen Manipulator, insbesondere einen mehrachsigen Manipulator, aufweisen. Die mobile Werkzeugmaschine kann eine Antriebsvorrichtung zum Antrieb eines Werkzeugs, beispielsweise eines Bohrers, eines Meißels, eines Saugers oder dergleichen aufweisen.

Die mobile Werkzeugmaschine kann beispielsweise zur Bearbeitung von Stein, wie Beton, und/oder Metall und/oder Holz eingerichtet sein. Sie kann beispielsweise zum Bohren, Meißeln, Sägen und / oder Schleifen ausgebildet sein.

Allgemein kann die mobile Werkzeugmaschine zur Ausführung von Arbeiten im Hoch- und/oder Tiefbau eingerichtet sein. Denkbar ist, dass sie nicht für einen Einsatz im Bergbau eingerichtet ist.

Die mobile Werkzeugmaschine kann tragbar sein; sie kann beispielsweise ein Gewicht von weniger als 50 kg, insbesondere von weniger als 25 kg, aufweisen.

Gemäß einem weiteren Aspekt wird ein Verfahren zum Herstellen einer Steuervorrichtung für eine mobile Werkzeugmaschine vorgeschlagen. Das Verfahren hat die Schritte: a) Bereitstellen einer bestückten Leiterplatte und eines Druckstücks, wobei das Druckstück einen Boden und mehrere Rippen hat, welche von dem Boden vorstehen und konfiguriert sind, um an die Leiterplatte anzuliegen, und wobei die Rippen zumindest einen Strömungskanal für einen Vergussmassenstrom von zumindest einem Einströmfenster zu zumindest einem Ausströmfenster bilden, b) Ausrichten der Leiterplatte zu dem Druckstück, sodass Bauelemente der Leiterplatte in den Strömungskanal hineinragen, und c) Einleiten einer Vergussmasse in den Strömungskanal. Mittels des Herstellungsverfahrens kann eine Steuervorrichtung bereitgestellt werden, dessen Bauelemente zumindest Lufteinschluss-arm durch die Vergussmasse gehalten und geschützt werden. Letztlich wird also eine sehr haltbare Steuervorrichtung bereitgestellt.

Man kann auch sagen, dass ein zu der Leiterplatte passendes Druckstück bereitgestellt wird.

Es kann sein, dass auch die bereits beschriebene Wärmeleitschicht bereitgestellt wird, und dass das Ausrichten ein Ausrichten der Wärmeleitschicht zu der Leiterplatte, oder umgekehrt, enthält. Man kann auch sagen, dass das Druckstück und die Wärmeleitschicht so zu der Leiterplatte ausgerichtet werden, dass das Druckstück und die Wärmeleitschicht an unterschiedliche Seite der Leiterplatte anliegen. Man kann sagen, dass das Druckstück und die Wärmeleitschicht überlappend ausgerichtet werden.

Es kann beispielsweise sein, dass eine vorbestimmte Menge an Vergussmasse mittels einer Dosiereinrichtung in den Strömungskanal eingeleitet wird. Beispielsweise kann es sein, dass ein Einleitungsdurchgriff in der Leiterplatte gebildet ist. Beispielsweise kann es sich um ein Loch mit einem Durchmesser unter 2 mm und beispielsweise ca. 1,4 mm handeln. Mittels der Dosiereinrichtung kann eine gleichbleibende Qualität sichergestellt werden.

In dieser Beschreibung wird die Idee des Leitens von Vergussmasse durch einen Strömungskanals von einem Einlassfenster um Bauelemente herum zu einem Auslassfenster einschließlich verschiedener Weiterbildungen bezüglich unterschiedlicher Aspekte (bezüglich der Komponente Druckstück, bezüglich des Systems Steuervorrichtung, bezüglich des übergeordneten System mobile Werkzeugmaschine und bezüglich des Herstellungsverfahrens) beschrieben. Die vorstehenden Aspekte sind daher nicht als getrennte Alternativen, sondern als einander ergänzende unterschiedlichen Blickwinkel aufzufassen. Merkmale und Erläuterungen sollen daher unter den Aspekten übertragbar sein.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

### KURZE BESCHREIBUNG DER FIGUREN

Die nachfolgende Beschreibung erläutert die Erfindung anhand von exemplarischen Ausführungsformen und Figuren. In den Figuren zeigt:
- Fig. 1: schematisch eine teilgeschnittene Ansicht einer mobilen Werkzeugmaschine, die eine Steuervorrichtung hat;
- Fig. 2: schematisch eine quergeschnittene Ansicht der Steuervorrichtung;
- Fig. 3: schematisch eine längsgeschnittene virtuelle Draufsicht auf ein Druckstück und auf in Strömungskanäle des Druckstücks von einer nicht dargestellten Leiterplatte hineinragende Bauelemente; und
- Fig. 4: schematisch ein Ablaufdiagramm eines Herstellungsverfahrens zum Herstellen der Steuervorrichtung.

Gleiche oder funktionsgleiche Elemente werden durch gleiche Bezugszeichen in den Figuren indiziert, soweit nichts anderes angegeben ist.

### AUSFÜHRUNGSFORMEN DER ERFINDUNG

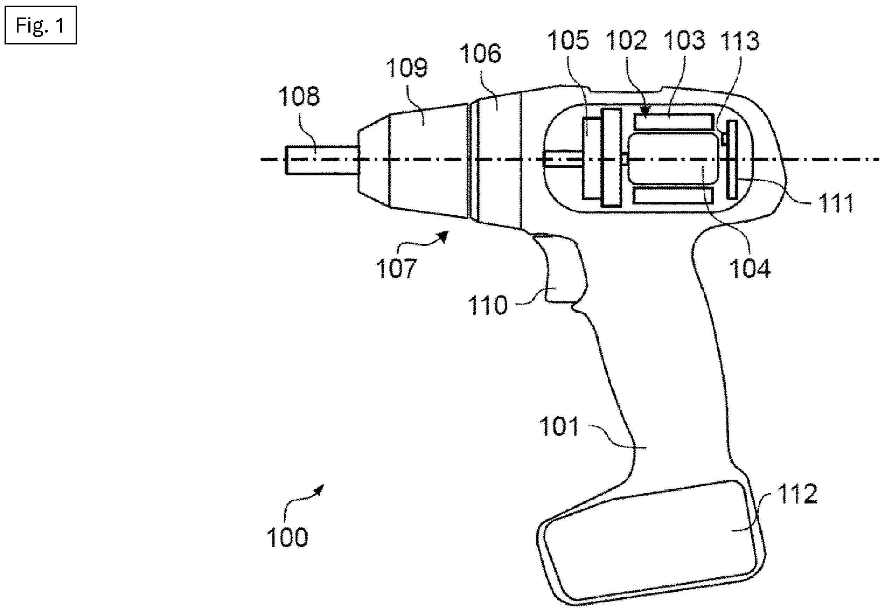

Die Fig. 1 zeigt eine mobile Werkzeugmaschine 100. Die Werkzeugmaschine 100 ist beispielhaft eine Handwerkzeugmaschine, genauer gesagt eine Bohrmaschine. Weitere bevorzugte Ausführungsformen umfassen eine Meißelmaschine, eine Schleifmaschine oder eine Sägemaschine. Die Werkzeugmaschine 100 hat ein Gehäuse 101 zum Schützen und Lagern weiterer Bauteile. Die Werkzeugmaschine 100 ist als tragbares Gerät ausgebildet. Sie weist beispielsweise ein Gewicht zwischen 0,5 und 15 kg und allgemein von weniger als 25 kg oder 50 kg auf.

Die Werkzugmaschine 100 hat einen Elektromotor 102, der einen Stator 103 und einen Rotor 104 hat. Der Rotor 104 ist beispielsweise über ein Getriebe 105 mit einer Spindel 106 einer Werkezugaufnahme 107 rotationsgekoppelt. Das Getriebe 105 ist beispielsweise ein Untersetzungsgetriebe. Es kann sein, dass das Getriebe 105 zwischen mehreren Übersetzungen schaltbar ist. Es kann sein, dass die Werkzeugmaschine 100 ein Schlagwerk enthält, das als Teil des Getriebes 105 oder der Werkzeugaufnahme 107 ausgeführt und/oder zwischen das Getriebe 105 und die Werkzeugaufnahme 107 geschaltet ist.

Die Werkzeugaufnahme 107 ist vorzugsweise zur Aufnahme eines wechselbaren Werkzeugs 108 konfiguriert. Beispielsweise kann durch ein Verdrehen eines Griffs 109 der Werkzeugaufnahme 107 gegenüber der Spindel 106 ein (nicht dargestelltes) Futter der Werkzeugaufnahme 107 geöffnet und/oder geschlossen werden. Beispielsweise handelt es sich um ein Schnellspannbohrfutter, ein SDS-Bohrfutter und/oder ein TE-C-Borfutter. Mittels der Werkzeugaufnahme 107 ist das Werkzeug 108 beispielsweise rotierend und/oder schlagend und/oder hämmernd antreibbar.

Der Elektromotor 102 ist beispielsweise ein bürstenloser Gleichstrommotor. Der Elektromotor 102 ist zum Erzeugen eines Drehmoments zwischen dem Stator 103 und dem Rotor 104 betreibbar. Eine Steuervorrichtung 111 ist dazu konfiguriert, auf eine Betätigung eines Betätigungselements 110 hin einen elektrischen Stromfluss von einer Stromquelle 112 zu dem Stator 103 zu schalten. Die Stromquelle 112 ist vorzugweise ein Akkumulator oder eine Schaltung mehrerer Akkumulatoren, sie kann aber auch ein Netzteil sein.

Beispielsweise ist die Steuervorrichtung 111 dazu eingerichtet, eine Rotationslage (Rotationswinkel und/oder Winkelgeschwindigkeit) des Rotors 104 relativ zu dem Gehäuse 101 mittels einer Hallsensorschaltung 113 zu erfassen. Beispielsweise ist die Steuervorrichtung 111 weiterhin dazu eingerichtet, (in Fig. 1 nicht dargestellte) Wicklungen des Stators 103 mit elektrischem Strom zu beaufschlagen. Die Steuervorrichtung 111 hat dazu beispielsweise eine Auswertelogik, und sie kann beispielsweise zum Ausführen eines Computerprogramms eingerichtet sein, dessen Befehle die Steuervorrichtung 111 dazu bringen, ein Verfahren zum Betreiben der mobilen Werkzeugmaschine 100 auszuführen.

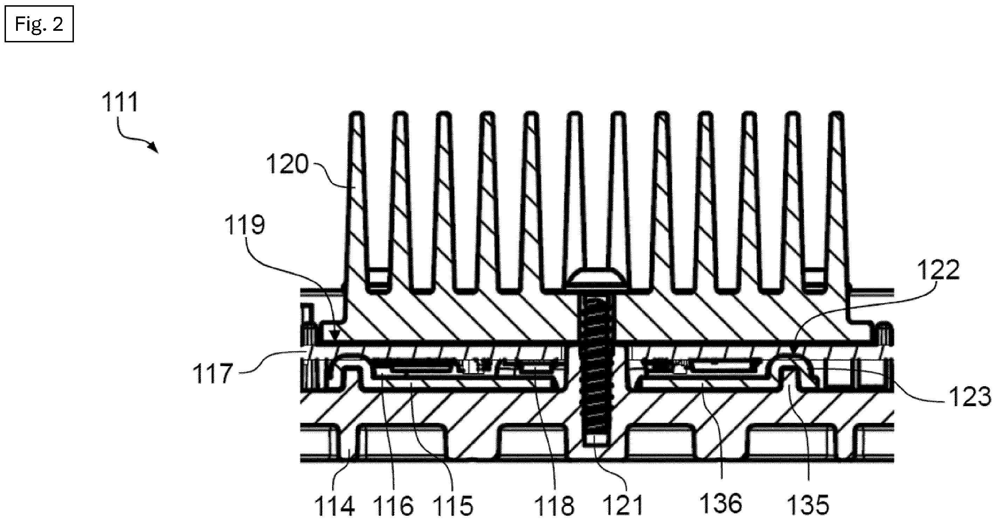

Die Fig. 2 zeigt einen Querschnitt durch die Steuervorrichtung 111. Hierbei ist ein Schichtaufbau der Steuervorrichtung 111 zu erkennen. Die Schichten der Steuervorrichtung 111 sind in dieser Reihenfolge von unten (in der Fig. 2, dies ist nicht zwingend eine Einbaulage in der Werkzeugmaschine 100 oder eine Betriebslage während eines Werkzeugbetriebs der Werkzeugmaschine 100): ein Gehäuse 114, ein Druckstück 115, eine ausgehärtete Vergussmasse 116, eine Leiterplatte 117 bestückt mit Bauelementen 118, eine Wärmeleitschicht 119 und ein Kühler 120.

Das Gehäuse 114 ist beispielsweise ein Gehäuse der Steuervorrichtung 111. Das Gehäuse 114 ist beispielsweise ein Spritzgussteil aus Kunststoff. Es ist beispielsweise eingerichtet, um als äußere Schutzschicht die Leiterplatte 117 und Bauelemente 118 vor Stäuben und Flüssigkeiten zu schützen, welche beispielsweise durch Lüftungsschlitze in das Innere des Gehäuses 101 der Werkzeugmaschine 100 gelangen können. Man kann sagen, dass die Leiterplatte 117 durch zwei Gehäuse umgeben ist, nämlich das äußere Gehäuse 101 der Werkzeugmaschine 100 und das innere Gehäuse 114 der Steuervorrichtung. Das Gehäuse 114 der Steuervorrichtung 111 ist beispielsweise dazu eingerichtet, als ein Baugruppenträger alle Komponenten (beispielsweise die Komponenten 115 bis 120, aber die Liste ist beispielhaft und nicht zwingend vollständig) der Steuervorrichtung 111 direkt oder indirekt zu lagern. Es kann sein, dass das Gehäuse 114 eine Aussparung für den Kühler 120 hat, sodass das Gehäuse 114 und der Kühler 120 eine Umhüllung der bestückten Leiterplatte 117 bilden.

Der Kühler 120 ist beispielsweise aus einem gut wärmeleitfähigen Werkstoff und/oder einem im Verhältnis zu seiner Dichte gut wärmeleitfähigen Werkstoff und/oder einem Werkstoff mit einem guten Wärmeübertragungskoeffizient zu Luft gebildet. Der Kühler 120 ist beispielsweise aus einem Metall gebildet, beispielsweise Aluminium oder Magnesium.

Wie man aus der Fig. 2 erkennen kann, überlappen sich das Druckstück 115, die Wärmeleitschicht 119 und der Kühler 120. Die Wärmeleitschicht 119 liegt beispielsweise nur in einem Bereich zwischen dem Kühler 120 und der Leiterplatte 117 vor. Die Wärmeleitschicht 119 kann beispielsweise auf ein Kontaktfläche des Kühlers 120 aufgebracht sein, welche als eine Wärmeaufnahmefläche des Kühlers 120 dient bzw. konfiguriert ist.

Das Druckstück 115 ist aus einem dauerhaft elastischen Material gebildet, beispielsweise ist das Druckstück 115 ein Silikonbauteil. Der Kühler 120 ist mittels einer Schraube 121 an dem Gehäuse 114 festgelegt. Das zwischen dem Gehäuse 114 und dem Kühler 120 komprimierte das Druckstück 115 erzeugt daher eine elastische Druckkraft (Federkraft) auf die Leiterplatte 117.

Funktional beschreiben kann man sagen, dass das Druckstück 115 die Leiterplatte 117 gegen die Wärmeleitschicht 119 drückt, um einen guten Wärmeübergang von der Leiterplatte 117 in die Wärmeleitschicht 119 zu gewährleisten. Beispielsweise kann eine Wärmeleitfolie als die Wärmeleitschicht 119 eingesetzt werden, wobei üblicherweise in einem Datenblatt oder dergleichen der Wärmeleitfolie ein einzustellender Druck auf die Wärmeleitfolie und/oder eine einzustellende Kompression der Wärmeleitfolie angegeben wird.

Mechanisch beschrieben kann man sagen, dass das Druckstück 115 die Leiterplatte 117 und die zwischengefügte Wärmeleitschicht 119 gegen den Kühler 120 drückt. Im Ergebnis stellt das Druckstück 115 ein Anpressen der bestückten Leiterplatte 117 gegen die Wärmeleitschicht 119 und der Wärmeleitschicht 119 gegen den Kühler 120 sicher, sodass eine rasche Wärmeabfuhr von den Bauelementen 118 bis zu dem Kühler 120 gewährleistet wird.

Die bestückte Leiterplatte 117 trägt die Bauelemente 118 und die ausgehärtete Vergussmasse 116. Dieser Block ist schwimmend gelagert zwischen dem nachgiebigen Druckstück 115 und der nachgiebigen Wärmeleitschicht 119.

Die Fig. 2 ist aus einer Konstruktionssoftware abgeleitet. Sie gibt daher keine elastische Verformung wieder. Daher sind Kontaktbereiche 122 zwischen Rippen 123 des Druckstücks 115 und unbestückten Bereichen der Leiterplatte 117 als Überlappungen gezeigt.

Die ausgehärtete Vergussmasse 116 füllt einen Zwischenraum zwischen dem Gehäuse 114 und der bestückten Leiterplatte 117 aus. Die bestückte Leiterplatte 117 ist so entworfen, dass die Bauelemente 118, welche im Betrieb die meiste Wärme erzeugen, im Bereich des Kühlers 120 angeordnet sind. Um eine gute Wärmeübertragung von der Leiterplatte 117 zu dem Kühler 120 zu erreichen, stehen die Bauelemente 118 zumindest im Bereich des Kühlers 120 an der von dem Kühler 120 abgewandten Seite der Leiterplatte 117 von der Leiterplatte 117 ab. Damit befinden sich diese Bauelemente 118 zwangsläufig auch im Bereich des Druckstücks 115. Somit ist ein Umströmen der Bauelemente 118 durch die Vergussmasse erschwert, und es kann zu Lufteinschlüssen gerade im Bereich des Druckstücks 115 kommen.

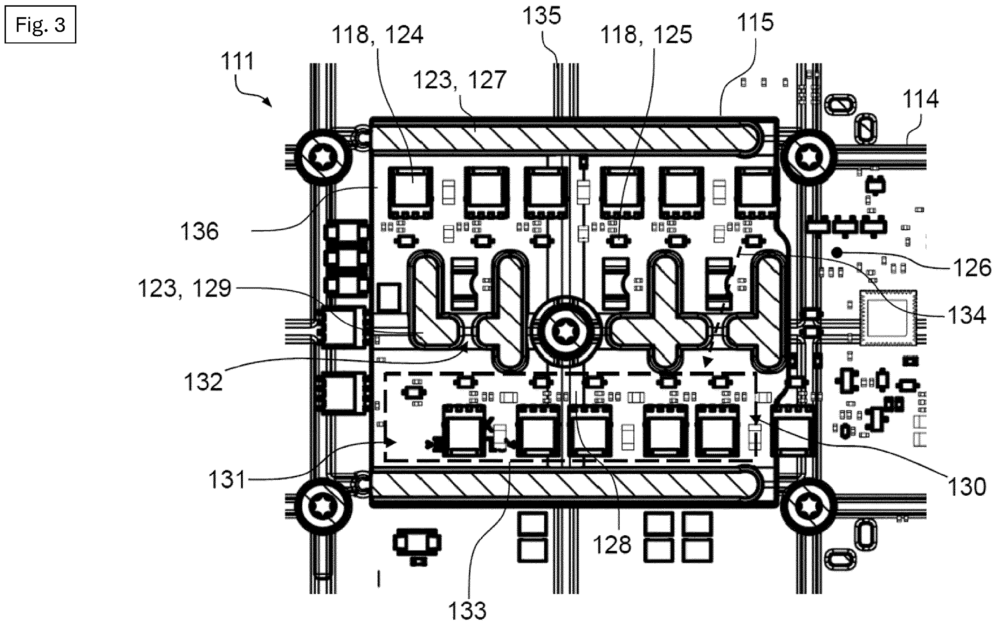

Im Folgenden wird anhand der Fig. 3 eine Gestaltung des Druckstücks 115 beschrieben, welche die Vergussmasse während eines Einbringens leitet, sodass es höchstens zu weniger oder kleineren Lufteinschlüssen kommt. Die Fig.3 ist eine Draufsicht auf das Druckstück 115, wobei sich eine Schnittebene zwischen dem Druckstück 115 und der Leiterplatte 117 befindet, sodass die Bauelemente 118 und das Druckstück 115 geschnitten gezeigt werden. Die Bauelemente 118 im Bereich des Kühlers 120 (d.h. im Bereich des Druckstücks 115) sind beispielsweise Leistungselektronikbauelemente, wie MOSFETs 124 und Shunts 125.

In der Leiterplatte 117 ist etwa mittig eine Öffnung zum Einbringen der Vergussmasse vorgesehen, deren Ort mit Bezugszeichen 126 illustriert wird. Während eines Herstellungsprozesses der Steuervorrichtung 111 wird mittels einer Dosiereinrichtung eine abgemessene bzw. vorbestimmte Menge dünnflüssige Vergussmasse in die Öffnung am Ort 126 eingebracht. Die Menge an Vergussmasse ist beispielsweise dazu bemessen, ein Volumen zwischen dem Gehäuse 114 und der Leiterplatte 117 auszufüllen.

Zum Verringen bzw. zum Vermeiden von Lufteinschlüssen bzw. zum Herstellen einer Lufteinschluss-armen (ausgehärteten) Vergussmasse hat das Druckstück 115 mehrere Rippen 123 zum Leiten der Vergussmasse. Die Rippen 123 stehen von einem Boden 136 vor.

Es gibt mehrere Arten von Rippen 123, nämlich seitliche Rippen 127 sowie innere Rippen 129. Zwischen den seitlichen Rippen 127 gibt es ein Einströmfenster 130, das eine dem Ort 126 des Einbringens zugewandte Lücke zwischen den seitlichen Rippen 127 ist. Zwischen den seitlichen Rippen 127 gibt es ein Ausströmfenster 131, das eine von dem Ort 126 des Einbringens abgewandte Lücke zwischen den seitlichen Rippen 127 ist. Zwischen inneren Rippen 129 oder zwischen je einer inneren Rippe 129 und einer seitlichen Rippe 127 kann es ein inneres Fenster 132 geben.

Jedes Einströmfenster 130 ist mit zumindest einen Ausströmfenster 131 durch einen Strömungskanal 133 verbunden, d.h. dass zumindest ein durchströmbarer Weg von dem Einströmfenster 130 zu dem Ausströmfenster 131 nicht durch eine Rippe 123 oder dergleichen vollständig blockiert ist. Der Begriff Strömungskanal umfasst auch Strömungspfadabschnitte 134 oder Strömungskanalabschnitte, welche sich im Bereich des Druckstücks 115 verzweigen und/oder vereinigen. Man kann beispielsweise sagen, dass als Strömungskanal 133 jede der Leiterplatte zugewandte Kavität des Druckstücks 115 angesehen werden kann, welche durch Rippen 123 begrenzt und mit zumindest einem Einströmfenster 130 und zumindest einem Ausströmfenster 131 verbunden ist. Man kann auch sagen, dass ein Strömungskanal 133 zwischen zumindest zwei der seitlichen und/oder inneren Rippen 127, 129 verläuft.

Es gibt auch nicht bis zu der Leiterplatte 117 hin von dem Druckstückboden 114 auskragende Wulste 128. Diese können zum Steuern eines Vergussmassestroms nach Art einer Drossel konfiguriert sein. Die Trennung in Wulste 128 und Rippen 123 gibt begrifflich wieder, dass Wulste 128 die Strömungskanäle 133 nicht definieren und nicht an die Leiterplatte 117 anliegen.

Die Bauelemente 118, 124, 125 ragen von der Leiterplatte 117 in die Strömungskanäle 132 hinein. Somit wirken die Rippen 123, 127, 129 und Wulste 128 als Leitmittel, welche den Strom der Vergussmasse während des Einfüllens bzw. den Strom der nicht-ausgehärteten Vergussmasse leiten. Die Rippen 123, 127, 129 wirken mit Reibungskräfte auf die Vergussmasse, sodass die Vergussmasse in Strömungsrichtung hinter einem Hindernis, d.h. dem jeweiligen Bauelement 118, zusammenströmt und letztlich Lufteinschlüsse im Bereich der Bauelemente 118, 124, 125 reduziert oder gar verhindert werden.

Eine in der Fig. 3 gezeigte beispielsweise Anordnung der Bauelemente 118 auf der Leiterplatte 117 und eine entsprechende Lage der Rippen 123 des Druckstücks 115 sind einander entsprechend gewählt, sodass jedes der in einen Strömungskanal 133 hineinragenden Bauelemente 118 auf einem geraden Strömungspfadabschnitt 134 zwischen zwei Fenstern 130, 131, 132 angeordnet ist. Dies stellt sicher, dass kein Bauelement 118 so in ein Eck zwischen zwei Rippen 123 platziert ist, dass ein Umströmen erschwert ist.

Die Rippen 123 und Wulste 128 des Druckstücks 115 werden beispielsweise durch Rippen 135 des Gehäuses 114 gestützt. Beispielsweise sind die Rippen 123, 127, 129 und Wulste 128 als Taschen gebildet, in welche jeweils eine Rippe 135 des Gehäuses eingreift. Dies ist eine beispielhafte Möglichkeit, um einerseits durch ein weiches Material des Druckstücks 115 eine Vorspannung auf die Wärmeleitschicht 119 einzustellen und andererseits einen Widerstand zum Leiten des ggf. zähen Stroms der Vergussmasse während eines Einströmens sicherzustellen. Beispielsweise kann es sein, dass die Rippen 123 und Wulste 128 als Taschen mit näherungsweise konstanter Wandstärke des Druckstücks 115 gebildet sind.

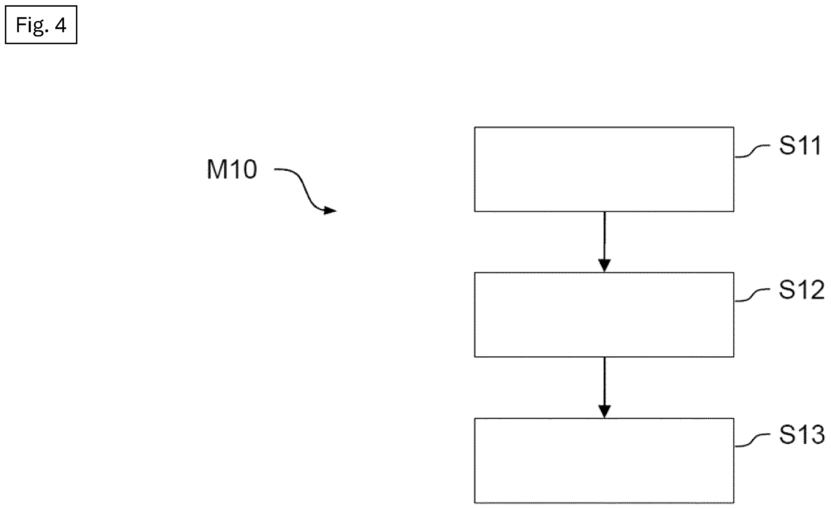

Als nächstes wird anhand der Fig. 4 kurz ein Herstellungsverfahren M10 für die Steuervorrichtung 111 beschrieben.

In einem ersten Schritt S11 werden die beschriebene bestückte Leiterplatte 117 und das beschriebene Druckstück 115 bereitgestellt. Außerdem wird die Wärmeleitschicht 119 bereitgestellt.

In einem nächsten Schritt S12 wird die bestückte Leiterplatte 117 so zu dem Druckstück 115 ausgerichtet, dass die Bauelemente 118, 124, 125 in jeweils einen Strömungskanal 133 hineinragen. Dazu kann man beispielsweise das Druckstück 115 an dem Gehäuse 114 festlegen, dann die bestückte Leiterplatte 117 einlegen, und dann die Leiterplatte 117 mittels der Wärmeleitschicht 119 und des Kühlers 112 durch die Schrauben 121 gegen Verrutschen sichern.

In einem nächsten Schritt S13 wird die Vergussmasse beispielsweise mittels einer Dosiereinrichtung (nicht gezeigt) durch den Eintritt an dem Ort 126 in den Strömungskanal 133 eingeleitet. Die Vergussmasse befindet sich beispielsweise in einem flüssigen und/oder nicht-ausgehärteten Zustand.

Während des Einleitens wird die Vergussmasse durch die Rippen 123, 127, 129 und Wulste 128 wie beschreiben geleitet, sodass die Vergussmasse die Bauelemente 118 umströmt und Lufteinschluss-arm oder Lufteinschluss-frei umgibt. Die Vergussmasse härtet dann beispielsweise aus, und sie bildet die ausgehärtete Vergussmasse 116.

Es kann sein, dass die Vergussmasse vor dem Einleiten in Schritt S13 mit Zuschlagstoffen versetzt wird, sodass sie beispielsweise eine höhere Wärmeleitfähigkeit erlangt. Auf diese Weise kann die ausgehärtete Vergussmasse 116 zusätzlich beispielsweise als thermischer Puffer konfiguriert werden.

Obwohl die vorliegende Erfindung anhand von Ausführungsbeispielen beschrieben wurde, ist sie vielfältig modifizierbar.

### BEZUGSZEICHENLISTE

- 100: mobile Werkzeugmaschine
- 101: Gehäuse
- 102: Elektromotor
- 103: Stator
- 104: Rotor
- 105: Getriebe
- 106: Spindel
- 107: Werkzeugaufnahme
- 108: Werkzeug
- 109: Griff
- 110: Betätigungselement
- 111: Steuervorrichtung
- 112: Stromquelle
- 113: Hallsensorschaltung
- 114: Gehäuseboden
- 115: Druckstück
- 116: Vergussmasse
- 117: Leiterplatte
- 118: Bauelement
- 119: Wärmeleitschicht
- 120: Kühler
- 121: Schraube
- 122: Kontaktbereich
- 123: Rippe
- 124: Leistungselektronikbauelement / MOSFET
- 125: Leistungselektronikbauelement / Shunt
- 126: Ort eines Vergussmasse-Einbringens
- 127: seitliche Rippe
- 128: Wulst
- 129: innere Rippe
- 130: Einströmfenster
- 131: Ausströmfenster
- 132: inneres Fenster
- 133: Strömungskanal
- 134: Strömungspfad
- 135: Gehäuserippen
- 136: Bodenabschnitt
- M10: Verfahren zum Herstellen einer Steuervorrichtung
- S11: Erfassen eines Rotationswinkels
- S12: Beaufschlagen eines Stators mit elektrischem Strom
- S13: Einleiten der Vergussmasse in den Strömungskanal

## Patentansprüche

1. Druckstück (115) für eine Steuervorrichtung (111) für eine mobile Werkzeugmaschine (100) zum Andrücken einer bestückten Leiterplatte (117) an eine Wärmeleitschicht (119), enthaltend einen Boden (136) und zumindest zwei Rippen (123, 127, 129), welche von dem Boden (136) vorstehen, wobei zwischen den Rippen (123, 127, 129) zumindest ein Strömungskanal (133) von zumindest einem Einströmfenster (130) zu zumindest einem Ausströmfenster (131) gebildet ist, welcher zum Leiten eines Vergussmassestroms von dem Einströmfenster (130) um zumindest ein in den Strömungskanal (133) hineinragendes Bauelement (118, 124, 125) herum zu dem Ausströmfenster (131) konfiguriert ist.

2. Druckstück nach Anspruch 1, wobei das Druckstück (115) aus einem dauerhaft elastischen Material, insbesondere aus Silikon, gefertigt ist.

3. Druckstück nach Anspruch 1 oder 2, wobei zumindest eine innere Rippe (129) von zumindest einem Strömungskanal (133) umgeben ist.

4. Druckstück nach einem der Ansprüche 1 bis 3, wobei zumindest eine Rippe (129) in einem eine Tasche ausbildenden Bereich durch ein Fenster (132) unterbrochen ist.

5. Steuervorrichtung (111) für eine mobile Werkzeugmaschine (100), enthaltend eine mit Bauelementen (118, 124, 125) bestückte Leiterplatte (117), eine Wärmeleitschicht (119) und ein Druckstück (115), welches einen Boden (136) und mehrere Rippen (123, 127, 129) hat, welche von dem Boden (136) vorstehen, wobei das Druckstück (115) angeordnet ist, sodass die Rippen (123, 127, 129) die Leiterplatte (117) gegen die Wärmeleitschicht (119) drücken, und wobei die Rippen (123, 127, 129) zumindest einen Strömungskanal (133) für einen Vergussmassenstrom von zumindest einem Einströmfenster (130) zu zumindest einem Ausströmfenster (131) bilden, und wobei Bauelemente (118, 124, 125) von der Leiterplatte (117) in den Strömungskanal (133) hineinragen.

6. Steuervorrichtung nach Anspruch 5, wobei das Druckstück (115) aus einem dauerhaft elastischen Material, beispielsweise aus Silikon, gefertigt ist, und/oder wobei zumindest eine innere Rippe (129) des Druckstücks von zumindest einem Strömungskanal (133) umgeben ist, und/oder wobei zumindest eine Rippe (129) in einem eine Tasche ausbildenden Bereich durch ein Fenster (132) unterbrochen ist.

7. Steuervorrichtung nach Anspruch 5 oder 6, wobei die Leiterplatte (117) mit Leistungselektronikbauelementen (124, 125) bestückt ist, wobei zumindest ein Teil der Leistungselektronikbauelemente (124, 125) zumindest ein Teil der in den Strömungskanal (133) hineinragende Bauelemente (118) ist, wobei die Leistungselektronikbauelemente (124, 125) beispielsweise gewählt sind aus: Feldeffekttransistoren, MOSFETs (124), Leistungstransistoren, Pulsdauermodulatoren, Gleichstrom-Wechselstrom-Umrichtern, Nebenschlusswiderständen und/oder Shunts (125).

8. Steuervorrichtung nach einem der Ansprüche 5 bis 7, wobei die in den Strömungskanal (133) hineinragenden Bauelemente (118, 124, 125) jeweils in einem Strömungspfad (134) zwischen zwei Fenstern (130, 131, 132) angeordnet sind.

9. Steuervorrichtung nach einem der Ansprüche 5 bis 8, wobei der zumindest eine Strömungskanal (133) mit einer Vergussmasse (116) vergossen ist.

10. Steuervorrichtung nach Anspruch 9, wobei die Vergussmasse (116) als thermischer Puffer konfiguriert ist.

11. Steuervorrichtung nach einem der Ansprüche 5 bis 10, wobei die Steuervorrichtung (111) einen Schichtaufbau in der folgenden Reihenfolge hat: ein Gehäuse (114), das Druckstück (115), die bestückte Leiterplatte (117), die Wärmeleitschicht (119) und ein Kühler (120).

12. Steuervorrichtung nach einem der Ansprüche 5 bis 11, wobei die Leiterplatte (117) zwischen dem Druckstück (115) und der Wärmeleitschicht (119) schwimmend gelagert ist.

13. Mobile Werkzeugmaschine (100), enthaltend eine Steuervorrichtung (111) nach einem der Ansprüche 5 bis 12.

14. Verfahren (M10) zum Herstellen einer Steuervorrichtung (111) für eine mobile Werkzeugmaschine (100), enthaltend die Schritte:
Bereitstellen (S11) einer bestückten Leiterplatte (117) und eines Druckstücks (115), wobei das Druckstück (115) einen Boden (136) und mehrere Rippen (123, 127, 129) hat, welche von dem Boden (136) vorstehen und konfiguriert sind, um an die Leiterplatte (117) anzuliegen, und wobei die Rippen (123, 127, 129) zumindest einen Strömungskanal (133) für einen Vergussmassenstrom von zumindest einem Einströmfenster (130) zu zumindest einem Ausströmfenster (131) bilden,
Ausrichten (S12) der Leiterplatte (117) zu dem Druckstück (115), sodass Bauelemente (118, 124, 125) der Leiterplatte (117) in den Strömungskanal (133) hineinragen, und
Einleiten (S13) einer Vergussmasse in den Strömungskanal (133).

15. Verfahren nach Anspruch 14, wobei eine vorbestimmte Menge an Vergussmasse mittels einer Dosiereinrichtung in den Strömungskanal (133) eingeleitet (S13) wird.
